(19) Europäisches Patentamt
European Patent Office
Office européen des brevets

(11) **EP 4 546 338 A1**

(12) **EUROPEAN PATENT APPLICATION**

(43) Date of publication:
**30.04.2025 Bulletin 2025/18**

(21) Application number: **24205487.2**

(22) Date of filing: **09.10.2024**

(51) International Patent Classification (IPC):
**G10L 21/034** (2013.01)    **G10L 25/78** (2013.01)

(52) Cooperative Patent Classification (CPC):
**G10L 21/034; G10L 25/78**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **24.10.2023 CN 202311388318**

(71) Applicant: **Harman International Industries, Inc.**
**Stamford, Connecticut 06901 (US)**

(72) Inventors:
• **LIU, Chuxuan**
**Stamford, CT, 06901 (US)**
• **ZHENG, Jianwen**
**Stamford, CT, 06901 (US)**
• **LI, Zhengxue**
**Stamford, CT, 06901 (US)**

(74) Representative: **Westphal, Mussgnug & Partner,**
**Patentanwälte mbB**
**Werinherstraße 79**
**81541 München (DE)**

(54) **METHOD AND SYSTEM FOR INTELLIGENT DYNAMIC SPEECH ENHANCEMENT**

(57)    The inventive subject matter provides a method and a system for intelligent dynamic speech enhancement for an audio source, comprising performing speech detection and intelligent enhancement gain control on a multi-channel audio source input to determine speech enhancement gain, and further comprising applying the speech enhancement gain in dynamic loudness balancing performed on the multi-channel audio source input, wherein the intelligent enhancement gain control comprises setting the speech enhancement gain based on a signal power strength ratio of a signal of a center channel to a sum of signals of other channels, and setting the speech enhancement gain based on a system volume level.

FIG. 1

EP 4 546 338 A1

## Description

### TECHNICAL FIELD

The inventive subject matter relates generally to the field of audio signal processing, and more particularly to a method and a system for intelligent dynamic speech enhancement for an audio source.

### BACKGROUND

With the popularity of high-definition cable TVs, online streaming, and large-screen display devices, the home theater experience is becoming increasingly popular in the marketplace. These media sources are typically equipped with multi-channel audio to provide users with a more immersive surround sound experience. However, since the primary purpose of the movie format is to provide highly immersive sound effects, speech clarity is often sacrificed in the pursuit of surround sound.

The speech enhancement technology plays a vital role in the filmmaking process and is designed to improve the quality, audibility, and clarity of the dialogue in the film material.

The development of the existing speech enhancement technology can be derived from the surround sound technology. For example, surround sound providers such as Dolby, THX, and DTS bring the multi-channel audio coding technology for better spatial resolution and stereo sound experience. This technology immerses the audience in a surround sound environment, but sometimes results in less clear dialogue in the mix. In addition, filmmaking includes a mixing process in which a sound mixer is responsible for adjusting the volume, balancing, and spatial positioning of different audio elements, including dialogue, music, and sound effects, in order to create a realistic listening effect. However, in the pursuit of an immersive surround sound experience, dialogue clarity tends to be compromised.

Therefore, there is a need for a method and a system for intelligent dynamic speech enhancement for an audio source to overcome the above disadvantages in the existing solutions.

### SUMMARY OF THE INVENTION

On the one hand, the inventive subject matter provides a method for intelligent dynamic speech enhancement. The method for intelligent dynamic speech enhancement comprises performing speech detection and intelligent enhancement gain control on a multi-channel audio source input to determine speech enhancement gain, the multi-channel audio source input comprising a signal of a center channel and signals of other channels. The method for intelligent dynamic speech enhancement further comprises applying the speech enhancement gain in dynamic loudness balancing performed on the multi-channel audio source input, wherein the intelligent enhancement gain control comprises setting the speech enhancement gain based on a signal power strength ratio of the signal of the center channel to a sum of the signals of the other channels, and setting the speech enhancement gain based on a system volume level.

On the other hand, the inventive subject matter provides a system for intelligent dynamic speech enhancement. The system for intelligent dynamic speech enhancement comprises a memory configured to store computer-executable instructions, and a processor configured to execute the computer-executable instructions to implement the method for intelligent dynamic speech enhancement.

### DESCRIPTION OF THE DRAWINGS

The inventive subject matter can be better understood by reading the following description of non-limiting implementations with reference to the accompanying drawings, in which:

FIG. 1 schematically illustrates a block diagram of the principle of intelligent speech enhancement according to one or more embodiments of implementations of the inventive subject matter;

FIG. 2 exemplarily illustrates a schematic block diagram of the principle of speech detection according to one or more embodiments of the inventive subject matter;

FIG. 3 exemplarily illustrates a schematic block diagram of the principle of intelligently controlling speech enhancement gain based on speech detection according to one or more embodiments of the inventive subject matter;

FIG. 4 exemplarily illustrates a plot of a non-linear volume correlation function according to one or more embodiments of the inventive subject matter;

FIG. 5 exemplarily illustrates a schematic diagram of a dynamic loudness balancing process according to one or more embodiments of the inventive subject matter; and

FIG. 6 schematically illustrates a flow chart of a method for intelligent dynamic speech enhancement according to one or more embodiments of the inventive subject matter.

## DETAILED DESCRIPTION

It should be understood that the following description of the embodiments is given for illustrative purposes only, and not restrictive. The division of the examples in the functional blocks, modules or units illustrated in the accompanying drawings should not be interpreted as indicating that these functional blocks, modules or units must be implemented as physically separated units. The functional blocks, modules or units illustrated or described may be implemented as separate units, circuits, chips, functional blocks, modules or circuit elements. One or more functional blocks or units may also be implemented in a common circuit, chip, circuit element or unit.

The use of singular terms (for example, but not limited to, "one") is not intended to limit the number of items. The use of relational terms, for example, but not limited to, "top", "bottom", "left", "right", "upper", "lower", "downward", "upward", "side", "first", "second" ("third", and the like), "entrance", "exit", and the like shall be used in written descriptions for the purpose of clarity in the specific reference to the accompanying drawings and are not intended to limit the scope of the inventive subject matter or the accompanying claims, unless otherwise indicated. The terms "couple", "coupling", "being coupled", "coupled", "coupler" and similar terms are used broadly herein and may include any method or apparatus for fixing, bonding, adhering, fastening, attaching, combining, inserting thereon, forming thereon or therein, and in communication therewith, or otherwise being directly or indirectly mechanically, magnetically, electrically, chemically, or operatively associated with an intermediate element, or one or more members, or may also include, but is not limited to, one member being integrally formed with another member in a uniform manner. The coupling may occur in any direction, including in a rotational manner. The terms "comprise/include" and "such as" are illustrative rather than restrictive and, unless otherwise indicated, the word "may" means "may, but does not have to". Notwithstanding the use of any other language in the inventive subject matter, the embodiments illustrated in the accompanying drawings are examples given for purposes of illustration and explanation and are not the only embodiments of the subject matter herein.

In order to improve the quality of the speech output and thereby provide a better listening experience to a user, the inventive subject matter proposes a solution for active detection of human speech based on detection confidence level scores and intelligent dynamic enhancement of speech loudness for an audio source (e.g., a theater audio source).

One speech enhancement method for improving the quality, audibility, and clarity of dialogue in, for example, a movie product utilizes static equalization techniques. The method may use a static equalizer that typically adjusts the frequency response within the range of 200 Hz to 4 kHz to increase the volume and the clarity of the dialogue range, thereby emphasizing the speech dialogue. However, the disadvantage of this approach is that its processing of the audio is activated throughout the audio clipping, resulting in unbalanced sound even in the absence of dialogue and amplifying background noise at the same time. Another dynamic speech enhancement method is to detect speech signals in each time frame and apply adaptive audio processing based on the result of the detection. This method enables sound to be enhanced when the speech is detected so as to improve the clarity and the intelligibility of the dialogue. However, this method requires very accurate and fast speech detection algorithms to process the sound quickly.

However, when speech enhancement is applied continuously at high system volumes, there are some side effects of continuous speech enhancement. For example, it can lead to perceptual imbalances and loss of dynamics in the listening experience. In addition, in audio clips where only speech signals are present, speech may already be clear and not need further enhancement. Accordingly, in order to obtain reasonable audio processing and enhancement methods to improve the quality of dialogue in a movie product and to allow viewers to better understand and appreciate the content of the movie, the disclosure of the inventive subject matter provides a method and a system for further optimized and intelligent dynamic speech enhancement.

The inventive subject matter focuses on a multi-channel audio source input from which speech and environment channels in an audio source can be easily extracted and directly analyzed.

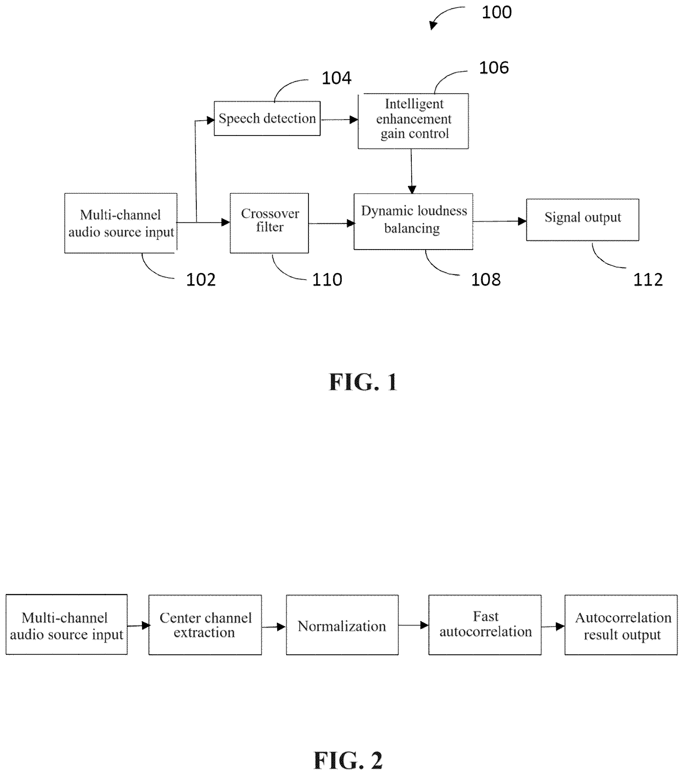

FIG. 1 schematically illustrates a block diagram 100 of the principle of intelligent speech enhancement according to one or more embodiments of implementations of the inventive subject matter. For ease of understanding, the implementation of the inventive subject matter is illustrated with primary reference to a number of modules. It is to be understood that the illustration with reference to the modules is intended to describe this solution more clearly and is not intended to be limiting.

The audio source input that can be handled by this system may include a single channel source input, a dual channel source input, and a multi-channel audio source input. In the home theater example, the audio source input can typically be considered to be a multi-channel audio source input that has been configured. For example, in a 5.1 Dolby surround sound theater, the audio source input can typically include one bass channel and five surround channels, where these five surround channels include a center channel, a left front channel, a right front channel, a left rear channel, and a right rear channel. In the case of the multi-channel audio source input, most of the speech signals are usually present in the center channel, and the other channels (i.e., the left front channel, the right front channel, the left rear channel, and the right rear channel, or the like) can be considered to include the surrounding environment channels. Accordingly, in an example of the inventive subject matter, the speech detection processing in the speech detection module uses a method for detecting speech in the center channel.

As shown in FIG. 1, the multi-channel audio source signals first enter the system for intelligent dynamic speech enhancement from a multi-channel audio source input module 102. This multi-channel audio source input may enter a speech detection module 104 for speech detection.

FIG. 2 exemplarily illustrates a schematic block diagram of the principle of speech detection according to one or more embodiments of the inventive subject matter. The speech detection process in FIG. 2 may be performed, for example, by the speech detection module 104 in FIG. 1. In this speech detection module 104, center channel extraction is first performed on the multi-channel audio source input, where most of the speech signals are present in the center channel. Then, normalization is performed on the extracted signal of the center channel such that the input signal is adjusted to a similar level on a proportional basis. The normalized signal is expressed, for example, in the following equation:

$$x_{i\_\text{norm}}(n) = (x_i(n) - \mu_i)/\sigma_i \tag{1}$$

where $x_i(n)$ denotes the input signal of the nth sampling point of the $i$th time frame, and $x_{i\_norm}(n)$ denotes the output signal, i.e., the normalized signal, of the $n$th sampling point of the ith time frame. $\mu_i$ and $\sigma_i$ are the mean and variance corresponding to the input signal of the $i$th time frame.

Next, fast autocorrelation processing is performed on the normalized signal and the autocorrelation result is output. For example, the fast autocorrelation processing may first perform a Fourier transform on the normalized input signal using a short-time Fourier transform (STFT) method and perform fast autocorrelation on the Fourier-transformed signal. For example, for the fast autocorrelation processing, reference is made to the following Equations (2)-(4).

$$X_i(z) = \text{STFT}\left(x_{i\_\text{norm}}(n)\right) \tag{2}$$

$$c_i(n) = \text{iSTFT}\left(X_i(z) * \overline{X_i(z)}\right) \tag{3}$$

$$C_i = \text{norm}\left(c_i(n)\right) \tag{4}$$

where $X_i(z)$ is the Fourier transformed signal, $\overline{X_i(z)}$ denotes the conjugate of $X_i(z)$, iSTFT is the inverse short-time Fourier transform, and $c_i(n)$ is the autocorrelation of the signal of the $i$th time frame. Next, the norm of $c_i(n)$ is calculated to obtain $C_i$. For example, the output $C_i$ of the final autocorrelation result is obtained based on the Euclidean norm. The output $C_i$ of the autocorrelation result denotes a detection confidence level, where the detection confidence level may be indicative of the possibility of speech being present in the signal of the center channel.

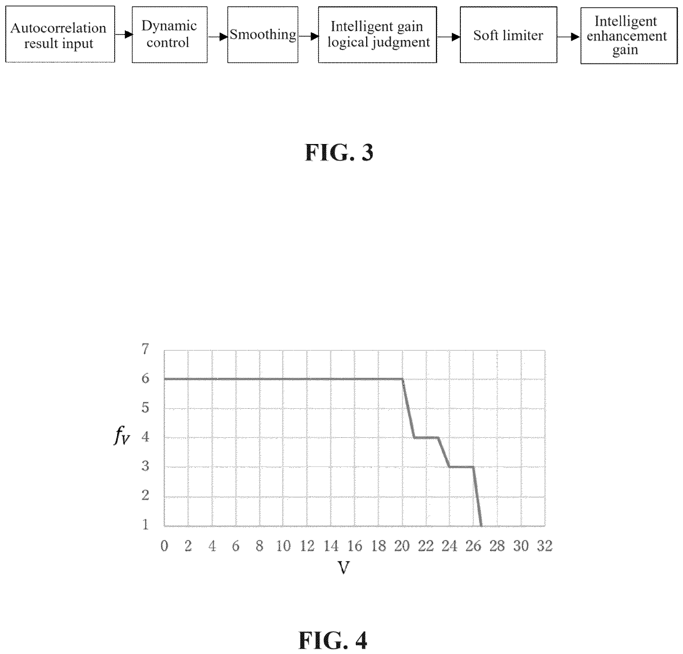

Next, FIG. 3 exemplarily illustrates a schematic block diagram of the principle of intelligently controlling speech enhancement gain based on speech detection according to one or more embodiments of the inventive subject matter. The processing of this step may correspond to the processing of the intelligent enhancement gain control module 106 in FIG. 1. As can be seen from the previous description, the input to this intelligent enhancement gain control module is the detection confidence level, which is just the signal correlation result that needs to be transformed into the enhancement gain of the speech.

The dynamic range of the enhancement gain can be defined as follows:

$$G_i = D_0 * \ln(C_i + D_1) \tag{5}$$

where $G_i$ denotes the gain of the dynamic control module, $C_i$ represents the aforementioned detection confidence level, and $D_0$ and $D_1$ are control parameters for a dynamic gain fluctuation range, which control parameters may be real numbers greater than zero; and $\ln(\cdot)$ is a natural logarithmic function.

In some examples, further processing of the enhancement gain $G_i$ is needed to reduce audio distortion. For example, smoothing processing can be performed on $G_i$.

In one or more implementations of the inventive subject matter, for the gain $G_i$, when speech enhancement is applied continuously at high system volumes, the continuous enhancement of the speech can lead to side effects, for example, perceptual imbalance and loss of dynamics, in the listening experience. In addition, in scenarios where only speech signals are present, for these audio clips where the speech is already clear, there is no longer a need to apply further gain processing to enhance the speech signals. Accordingly, with respect to these proposed side effects, the inventive subject matter further provides intelligent logical judgment and intelligent enhancement gain processing to intelligently optimize speech enhancement gain processing.

In an example, in the intelligent logical judgment, the setting of the speech enhancement gain is judged by means of the comparison of the signal power strength of the center channel to the other channels. Specifically, in one or more embodiments of the inventive subject matter, the energy of the signals of the other channels is first extracted and summed and then compared to the energy of the center channel. For example, when there exists a speech signal in the center channel and the surrounding environment sound in the other channels is loud, the speech enhancement gain needs to be set high, while, for example, when there exists a speech signal in the center channel but the environment sound in the other channels is weak, the speech enhancement gain needs to be set low. As expressed in the following equation:

$$G_p = \left(\frac{P_c}{P_o}\right) * \alpha \qquad (6)$$

where $G_p$ is the gain of the intelligent speech enhancement control module, ($\frac{P_c}{P_a}$) is a power ratio of the center channel to the other channels, $P_c$ is the power of the center channel, $P_o$ is the sum of the power of the other channels, and $\alpha$ is a limiting parameter according to the system configuration.

In other words, the speech enhancement gain needs to be set high when the signal power strength ratio of the center channel to the sum of the other channels is small; and the speech enhancement gain can be set low when the signal power strength ratio of the center channel to the sum of the other channels is large.

By performing a logical judgment of the signal power strength ratio of the center channel to the sum of the other channels and comparing the relative strength of the environment sound based on the vocal dialogue in the audio clip, the problem of perceptual imbalance in enhancing the audio sound can be solved, and in the case of poor audibility and clarity due to a strong environment sound and an insufficiently prominent human voice, the user is provided with better listening perception by further intelligently optimizing the gain of the human voice dialogue.

In an example, in the intelligent logical judgment, the setting of the speech enhancement gain is judged by means of the system volume of an audio source, for example, a movie product. The current system volume level can be recognized, and then different speech enhancement gain can be set within different volume ranges recognized. For example, the current system volume level is recognized, and when the system volume level is within a low range, the speech enhancement gain can be set high, while when the system volume level is within a high range, the speech enhancement gain should be set low. For example, when the current system volume level exceeds a threshold, the speech enhancement gain may be set to 1, i.e., making the loudness level unchanged for the speech signal.

FIG. 4 exemplarily illustrates a plot of a non-linear volume correlation function according to one or more embodiments of the inventive subject matter. The volume range of the speech enhancement gain may be defined as follows:

$$G_v = f_V\left(G_i * G_p\right) \qquad (7)$$

wherein $G_v$ denotes the output of the intelligent speech enhancement control module, $f_V$ is a non-linear volume correlation function; and as described above, $G_i$ denotes the gain of the dynamic control module, and $G_p$ is the gain of the intelligent speech enhancement control module. The plot of this non-linear volume correlation function may be as shown, for example, in FIG. 4, where the horizontal axis represents the system volume level, and the vertical axis represents the gain setting. As can be seen from FIG. 4, within a range where the system volume is small, for example, when the system volume level is smaller than 20, the speech enhancement gain can be set high, for example, a gain of 6 dB. As the system volume increases, the setting of the speech enhancement gain decreases when it reaches a range where the system volume is high. For example, when the system volume level exceeds 20, the curve of the non-linear volume correlation function of the speech enhancement gain decreases to 4 dB, and when the system volume level reaches 24, the speech enhancement gain is 3 dB. When the system volume level further increases to 26, the gain setting for speech gradually decreases to 1, which means that the system maintains the speech volume without enhancement, so as to avoid the impact of audio distortion on the sense of hearing caused by too high a volume.

Finally, a soft limiter can also be used for limiting processing. For example, a tanh function can be used as the soft limiter to ensure that the enhancement gain $G_{v_{lim}}$ after limiting is within a reasonable amplitude range. This soft limiter processing can be expressed as:

$$G_{v_{lim}} = \tanh(\alpha G_v + \beta) + \gamma \qquad (8)$$

wherein $\alpha$, $\beta$, and $\gamma$ are limiter parameters according to the system configuration and these parameters depend on the

system configuration, where $\alpha$ may be a real number greater than zero, and $\beta$ and $\gamma$ may be non-zero real numbers. At this point, $G_{Vlim}$ is the result of the intelligent enhancement gain processing, which can be used as an output of the intelligent enhancement gain control module.

By performing the logical judgment as mentioned above by recognizing the system volume level of the film product and according to the strength of the system volume in the audio clip, it is possible to avoid audio distortion caused by too much enhancement of the speech dialogue when the volume is enhanced to a greater strength, thus further intelligently optimizing the dynamic speech gain, which enables the user to obtain a better auditory perception.

By means of the above logical judgment of two aspects, namely, the signal power strength ratio of the center channel to the sum of the other channels as well as the system volume level, it is possible to intelligently optimize the processing of the dynamic speech enhancement so as to further improve the user experience, thereby intelligently adjusting the speech enhancement for various scenarios in the diversified film product sources. Therefore, the use of this method undoubtedly enables the user to obtain a better movie viewing experience.

The intelligent dynamic processing provided in the inventive subject matter is all directed to speech enhancement. Since the frequency range of the human voice is substantially within the mid-frequency range, e.g., between 250-4000 Hz, the dynamic loudness balancing module 108 in the inventive subject matter may also focus primarily on the mid-frequency range of the input audio source signals for processing. Therefore, a crossover filter may be used to first crossover the inputted audio signals, for example, in FIG. 1, making the inputted audio signals enter the crossover filter module 110 for crossover filtering in order to distinguish signals of different frequency ranges such as low-frequency signals, mid-frequency signals, and high-frequency signals, and then the separated mid-frequency signals may be made to enter the dynamic loudness balancing module 108 for dynamic loudness balancing processing. Moreover, the intelligent enhancement gain control module is also only applied to the speech signals within the mid-frequency range in the multi-channel audio source input and outputs the enhancement gain, while signals in the other frequency ranges in the inputted signals can remain unchanged. Separate processing of mid-frequency range signals and other high-frequency and low-frequency range signals in the multi-channel audio source input can be achieved by means of crossover filtering processing, so as to reduce as much as possible audio distortions within the non-speech frequency ranges.

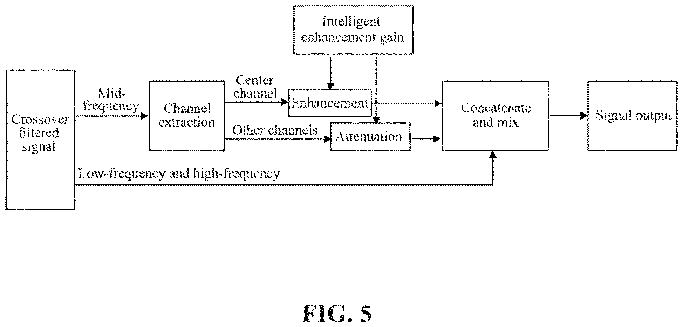

FIG. 5 exemplarily illustrates a schematic diagram of a dynamic loudness balancing process according to one or more embodiments of the inventive subject matter. Optionally, the signals of the multi-channel audio source input after the crossover filtering may be divided into low-frequency, mid-frequency and high-frequency range signals by means of crossover. The dynamic loudness balancing module can perform dynamic loudness balancing only on signals within the mid-frequency range. Here, for the signal of the center channel extracted by means of channel extraction, the loudness of the signal of the center channel may be enhanced, for example, based on the intelligent enhancement gain, while optionally, the loudness of the signals of the other channels may be attenuated. For example, based on the intelligent enhancement gain, the signals in the center channel and the signals in the other channels can be separately enhanced and/or attenuated at different ratios, and then concatenated and mixed to generate the signal output. In addition, the low-frequency range and high-frequency range signals in the multi-channel audio source input after crossover filtering processing will not be subjected to dynamic loudness balancing processing here, but will be directly concatenated and mixed with the mid-frequency range signals after dynamic loudness balancing to generate the signal output. For example, the signal is outputted by the signal output module 112 illustrated in FIG. 1. As a result, a reduction in audibility or clarity brought about by non-speech signals can be better reduced.

Returning to FIG. 1, as can be seen, the method for intelligent dynamic speech enhancement in the inventive subject matter is mainly divided into two paths for processing, where the upper layer path comprises the audio source input, the speech detection, and the intelligent enhancement gain, and this path is regarded as the side-chain processing flow for performing the detection. The lower layer path includes the main-chain processing flow consisting of the audio source input, the crossover filtering, and the dynamic loudness balancing. The upper layer path and the lower layer path can be performed synchronously or asynchronously, which will depend on the capability and latency requirements of the actual system. This approach to performing intelligent dynamic speech enhancement in a two-path fashion can minimize latency and prevents audio distortion. When these two layers of paths work asynchronously, signals can travel through the entire system at very fast speeds with little to no latency. On the other hand, estimating the enhancement gain at a relatively low rate can have higher precision and smoothness, which significantly helps prevent audio distortion.

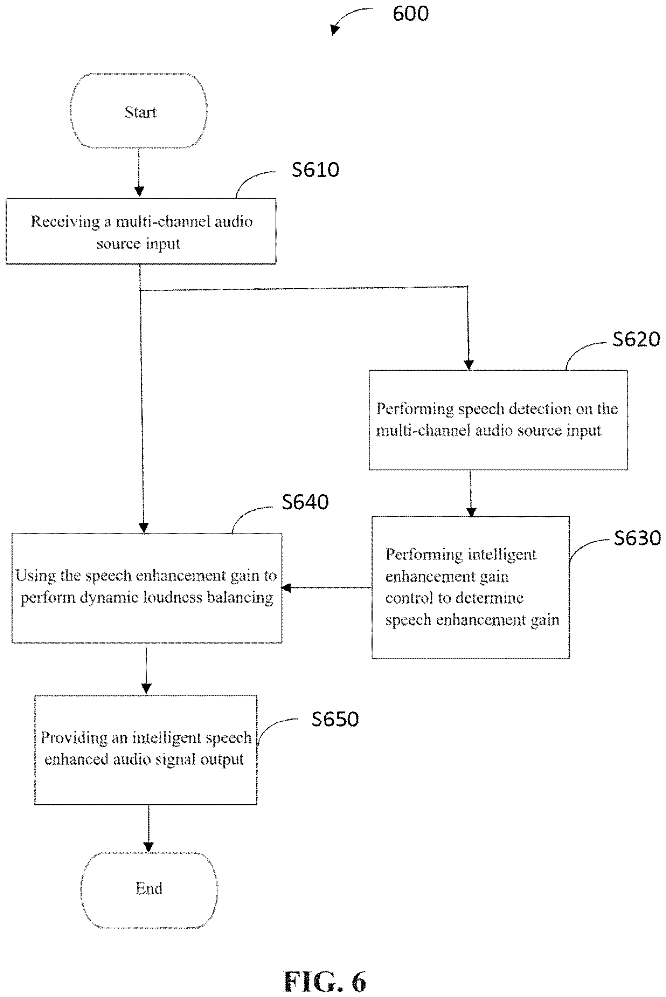

FIG. 6 schematically illustrates a flow chart 600 of a method for intelligent dynamic speech enhancement according to one or more embodiments of the inventive subject matter. As shown in FIG. 6, this method for intelligent dynamic speech enhancement may include, in step S610, receiving a multi-channel audio source input. Then, in step S620, speech detection is performed on the multi-channel audio source input of the side-chain processing flow path. Next, in step S630, intelligent enhancement gain control is performed on a detected speech to determine speech enhancement gain. In step S640, the determined speech enhancement gain is used to perform dynamic loudness balancing for the multi-channel audio source input in the main-chain processing flow; and finally, in step S650, this method for intelligent dynamic speech enhancement may provide an intelligent speech enhanced audio signal output.

Additionally or alternatively, the steps of the method for intelligent dynamic speech enhancement as shown in FIG. 6 may be implemented by one or more processors. The processors may be implemented as microprocessors, microcontrollers, application-specific integrated circuits (ASICs), digital signal processors (DSPs), discrete logic, or combinations of these and/or other types of circuitry or logic. Similarly, instructions for implementing the method for intelligent dynamic speech enhancement as shown in FIG. 6 may be stored in a memory, which may be DRAM, SRAM, flash memory, or other type of memory. Parameters (e.g., conditions and thresholds) and other data structures can be stored and managed separately, can be consolidated into a single memory or database, or can be logically and physically organized in many different ways. Programs and instruction sets may be parts of a single program, or may be separate programs, or distributed across multiple memories and processors.

The method and the system for intelligent dynamic speech enhancement provided in the inventive subject matter can be used not only for consumer products such as Soundbars and stereo speakers, but also for applications in occasions such as theaters and concert halls. Compared to static audio equalization and static speech enhancement techniques, the method and the system for intelligent dynamic speech enhancement provided in the inventive subject matter can improve speech clarity by means of intelligent gain control. In the method for intelligent dynamic speech enhancement provided in the inventive subject matter, optimization is performed for the existing speech enhancement technology so as to intelligently incorporate dynamic speech enhancement gain control in applications such as theaters, for example, thereby enabling an improved user experience for a diversity of movie clips, including, and not limited to: fast implementation of speech activity detection based on the center channel; intelligent enhancement gain control that intelligently adjusts the speech enhancement gain level according to the movie content and intelligently adjusts the speech enhancement gain level according to the volume of the playback system; and implementation of multi-channel intelligent dynamic loudness balancing using dual processing paths.

Examples of one or more implementations of the inventive subject matter are described in the following clauses:

Clause 1. performing speech detection and intelligent enhancement gain control on a multi-channel audio source input to determine speech enhancement gain, the multi-channel audio source input comprising a signal of a center channel and signals of other channels;
applying the speech enhancement gain in dynamic loudness balancing performed on the multi-channel audio source input, wherein the intelligent enhancement gain control comprises:

setting the speech enhancement gain based on a signal power strength ratio of the center channel to a sum of the other channels, and
setting the speech enhancement gain based on a system volume level.

Clause 2. The method for intelligent dynamic speech enhancement of clause 1, wherein setting the speech enhancement gain based on a signal power strength ratio of the center channel to a sum of the other channels comprises:

setting the speech enhancement gain to be high when the signal power strength ratio of the center channel to the sum of the other channels is small; and
setting the speech enhancement gain to be low when the signal power strength ratio of the center channel to the sum of the other channels is large.

Clause 3. The method for intelligent dynamic speech enhancement of clause 1 or 2, wherein setting the speech enhancement gain based on a system volume level comprises:

recognizing the system volume level and setting different speech enhancement gain when the recognized system volume level is within different volume ranges,
wherein the speech enhancement gain is set to be high when the system volume level is within a low range, and
wherein the speech enhancement gain is set to be low when the system volume level is within a high range.

Clause 4. The method for intelligent dynamic speech enhancement of any one of clauses 1 to 3, wherein the speech detection comprises:

extracting the signal of the center channel from the multi-channel audio source input;
performing normalization on the signal of the center channel; and
performing fast autocorrelation on the normalized signal of the center channel, a result of the fast autocorrelation representing a detection confidence level which is indicative of the possibility of speech being present in the signal of the center channel.

Clause 5. The method for intelligent dynamic speech enhancement of any one of clauses 1 to 4, wherein the intelligent enhancement gain control further comprises:

converting the detection confidence level to the speech enhancement gain; and
performing smoothing processing on the speech enhancement gain.

Clause 6. The method for intelligent dynamic speech enhancement of any one of clauses 1 to 5, wherein the intelligent enhancement gain control further comprises performing soft limiting processing on the set speech enhancement gain.
Clause 7. The method for intelligent dynamic speech enhancement of any one of clauses 1 to 6, wherein the dynamic loudness balancing performed on the multi-channel audio source input comprises:

enhancing the loudness of the signal of the center channel and attenuating the loudness of the signals of the other channels based on the set speech enhancement gain; and
performing concatenating and mixing processing on the enhanced signal of the center channel and the attenuated signals of the other channels to generate an output signal.

Clause 8. The method for intelligent dynamic speech enhancement of any one of clauses 1 to 7, further comprising: performing crossover filtering processing on the multi-channel audio source input prior to the dynamic loudness balancing performed on the multi-channel audio source input.
Clause 9. The method for intelligent dynamic speech enhancement of any one of clauses 1 to 8, further comprising:

performing the dynamic loudness balancing only on the multi-channel audio source input within a mid-frequency range; and
concatenating and mixing the multi-channel audio source input within the mid-frequency range that has undergone the dynamic loudness balancing with the multi-channel audio source input within a low-frequency range and a high-frequency range to generate an output signal.

Clause 10. A system for intelligent dynamic speech enhancement, comprising:

a memory configured to store computer-executable instructions; and
one or more processors configured to execute the stored computer-executable instructions to implement the method for intelligent dynamic speech enhancement of any one of clauses 1-9.

A description of implementations has been presented for illustrative and descriptive purposes. Appropriate modifications and changes to the implementations may be made in accordance with the above description, or may be obtained from the practice of the method. For example, one or more of the described methods may be performed by suitable apparatuses and/or combinations of apparatuses unless otherwise indicated. The method may be performed by executing the stored instructions with one or more logic apparatuses (e.g., processors) in conjunction with one or more additional hardware elements (such as storage apparatuses, memories, hardware network interfaces/antennas, switches, actuators, clock circuits, and so on). In addition to the order described in the present application, the described methods and associated actions may also be performed in various sequences in parallel and/or simultaneously. The systems described are exemplary in nature and may include additional elements and/or omit elements. The subject matter of the inventive subject matter includes all novel and non-obvious combinations of the various systems and configurations and other features, functions, and/or properties disclosed.

The elements of various real-time schemes for modules, elements, and components for implementing the methods provided in the inventive subject matter may be fabricated as one or more electronic devices, including but not limited to arrays of fixed or programmable logic elements (e.g., transistors or gates, or the like), residing on the same chip or in a chipset. One or more elements of the various implementations of the devices described herein may also be implemented, in whole or in part, as one or more instruction sets, which may be arranged to be executed on one or more arrays of fixed or programmable logic elements (e.g., microprocessors, embedded processors, IP cores, digital signal processors, FPGAs, ASSPs, and ASICs, and so on).

The terminology used herein has been chosen to best explain the principles of the embodiments, the practical applications or the improvements to the technology found in the market, or to enable those of ordinary skill in the art to understand the embodiments disclosed herein.

In the foregoing, the embodiments presented in the inventive subject matter are identified by reference. However, the scope of the inventive subject matter is not limited to the specifically described embodiments. Rather, any combination of the foregoing features and elements, whether or not involving different embodiments, is envisioned to implement and practice the envisioned embodiments.

Furthermore, while the embodiments disclosed herein can achieve advantages over other possible solutions or over the prior art, whether or not a given embodiment achieves a particular advantage does not limit the scope of the inventive subject matter. Accordingly, the foregoing aspects, features, embodiments, and advantages are merely illustrative and are not considered to be elements or limitations of the appended claims unless expressly set forth in the claims.

While the foregoing is directed to embodiments of the inventive subject matter, other and further embodiments of the inventive subject matter may be devised without departing from the essential scope of the inventive subject matter, and the scope of the inventive subject matter is determined by the appended claims.

**Claims**

1. A method for intelligent dynamic speech enhancement, comprising the steps of:

    performing speech detection and intelligent enhancement gain control on a multi-channel audio source input to determine speech enhancement gain, the multi-channel audio source input comprising a signal of a center channel and signals of other channels;
    applying the speech enhancement gain in dynamic loudness balancing performed on the multi-channel audio source input,
    wherein the intelligent enhancement gain control comprises:

        setting the speech enhancement gain based on a signal power strength ratio of the center channel to a sum of the other channels, and
        setting the speech enhancement gain based on a system volume level.

2. The method of claim 1, wherein setting the speech enhancement gain based on a signal power strength ratio of the center channel to a sum of the other channels comprises:

        setting the speech enhancement gain to be high when the signal power strength ratio of the center channel to the sum of the other channels is small; and
        setting the speech enhancement gain to be low when the signal power strength ratio of the center channel to the sum of the other channels is large.

3. The method of claim 1, wherein setting the speech enhancement gain based on a system volume level comprises:

        recognizing the system volume level and setting different speech enhancement gain when the recognized system volume level is within different volume ranges,
        wherein the speech enhancement gain is set to be high when the system volume level is within a low range, and
        wherein the speech enhancement gain is set to be low when the system volume level is within a high range.

4. The method of claim 1, wherein the speech detection comprises:

        extracting the signal of the center channel from the multi-channel audio source input;
        performing normalization on the signal of the center channel; and
        performing fast autocorrelation on the normalized signal of the center channel, a result of the fast autocorrelation representing a detection confidence level which is indicative of the possibility of speech being present in the signal of the center channel.

5. The method of claim 4, wherein the intelligent enhancement gain control further comprises:

        converting the detection confidence level to the speech enhancement gain; and
        performing smoothing processing on the speech enhancement gain.

6. The method of claim 1, wherein the intelligent enhancement gain control further comprises performing soft limiting processing on the set speech enhancement gain.

7. The method of claim 2 or 3, wherein the dynamic loudness balancing performed on the multi-channel audio source input comprises:

enhancing the loudness of the signal of the center channel and attenuating the loudness of the signals of the other channels based on the set speech enhancement gain; and

performing concatenating and mixing processing on the enhanced signal of the center channel and the attenuated signals of the other channels to generate an output signal.

8. The method of claim 7, further comprising: performing crossover filtering processing on the multi-channel audio source input prior to the dynamic loudness balancing performed on the multi-channel audio source input.

9. The method of claim 8, further comprising:

performing the dynamic loudness balancing only on the multi-channel audio source input within a mid-frequency range; and

concatenating and mixing the multi-channel audio source input within the mid-frequency range that has undergone the dynamic loudness balancing with the multi-channel audio source input within a low-frequency range and a high-frequency range to generate an output signal.

10. A system for intelligent dynamic speech enhancement, comprising:

a memory configured to store computer-executable instructions; and

one or more processors configured to execute the computer-executable instructions to implement the method for intelligent dynamic speech enhancement of any one of claims 1-9.

100

106

104

Speech detection

Intelligent
enhancement
gain control

Multi-channel
audio source input

Crossover
filter

Dynamic loudness
balancing

Signal output

102

110

108

112

**FIG. 1**

Multi-channel
audio source input

Center channel
extraction

Normalization

Fast
autocorrelation

Autocorrelation
result output

**FIG. 2**

| Autocorrelation result input | → | Dynamic control | → | Smoothing | → | Intelligent gain logical judgment | → | Soft limiter | → | Intelligent enhancement gain |

**FIG. 3**

**FIG. 4**

**FIG. 5**

600

Start

S610

Receiving a multi-channel audio
source input

S620

Performing speech detection on the
multi-channel audio source input

S640

Using the speech enhancement gain to
perform dynamic loudness balancing

S630

Performing intelligent
enhancement gain
control to determine
speech enhancement gain

S650

Providing an intelligent speech
enhanced audio signal output

End

**FIG. 6**

| | Europäisches Patentamt European Patent Office Office européen des brevets | **EUROPEAN SEARCH REPORT** | **Application Number** EP 24 20 5487 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2011/119061 A1 (BROWN CHARLES PHILLIP [US]) 19 May 2011 (2011-05-19) | 1,2,4, 6-10 | INV. G10L21/034 |
| A | * abstract * * paragraphs [0003], [0006], [0007], [0019], [0024] - [0026]; figure 2 * | 3,5 | G10L25/78 |
| | ----- | | |
| Y | US 10 600 432 B1 (CHU WAI CHUNG [US] ET AL) 24 March 2020 (2020-03-24) * abstract * * column 7, line 54 - column 8, line 26 * | 1,2,4, 6-10 | |
| | ----- | | |
| A | US 2023/040743 A1 (SHIH SHAO-FU [US] ET AL) 9 February 2023 (2023-02-09) * abstract * * paragraphs [0002] - [0004], [0006], [0007], [0032] - [0038], [0041] * | 1-10 | |
| | ----- | | |
| A | US 2013/006619 A1 (MUESCH HANNES [US]) 3 January 2013 (2013-01-03) * abstract * * paragraphs [0003], [0006] - [0008], [0015], [0019], [0027], [0047], [0048], [0051], [0052] * | 1-10 | TECHNICAL FIELDS SEARCHED (IPC) G10L |
| | ----- | | |

The present search report has been drawn up for all claims

| Place of search | Date of completion of the search | Examiner |
|---|---|---|
| The Hague | 9 January 2025 | Hofe, Robin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 5487

This annex lists the patent family members relating to the patent documents cited in the above-mentioned European search report.
The members are as contained in the European Patent Office EDP file on
The European Patent Office is in no way liable for these particulars which are merely given for the purpose of information.

09-01-2025

| Patent document cited in search report | Publication date | Patent family member(s) | | Publication date |
|---|---|---|---|---|
| US 2011119061 A1 | 19-05-2011 | NONE | | |
| US 10600432 B1 | 24-03-2020 | NONE | | |
| US 2023040743 A1 | 09-02-2023 | CN | 115881146 A | 31-03-2023 |
| | | EP | 4131265 A2 | 08-02-2023 |
| | | JP | 2023024295 A | 16-02-2023 |
| | | KR | 20230021580 A | 14-02-2023 |
| | | US | 2023040743 A1 | 09-02-2023 |
| US 2013006619 A1 | 03-01-2013 | BR | 112012022571 A2 | 30-08-2016 |
| | | BR | 122019024041 B1 | 11-08-2020 |
| | | CN | 102792374 A | 21-11-2012 |
| | | CN | 104811891 A | 29-07-2015 |
| | | EP | 2545552 A1 | 16-01-2013 |
| | | ES | 2709523 T3 | 16-04-2019 |
| | | JP | 5674827 B2 | 25-02-2015 |
| | | JP | 2013521541 A | 10-06-2013 |
| | | RU | 2012141463 A | 20-04-2014 |
| | | TW | 201215177 A | 01-04-2012 |
| | | US | 2013006619 A1 | 03-01-2013 |
| | | US | 2016071527 A1 | 10-03-2016 |
| | | WO | 2011112382 A1 | 15-09-2011 |

EPO FORM P0459

For more details about this annex : see Official Journal of the European Patent Office, No. 12/82